# EUROPÄISCHE PATENTSCHRIFT

(11) **EP 0 493 647 B1**
(45) Veröffentlichungstag und Bekanntmachung des Hinweises auf die Patenterteilung: **05.06.2002**
(21) Anmeldenummer: 91113004.5
(22) Anmeldetag: 02.08.1991
(51) Int. Cl.: H01J 37/32, C23C 14/34, H01J 37/34

(54) **Zerstäubungskathode für die Beschichtung von Substraten in Katodenzerstäubungsanlagen**
Sputtering cathode for substrate deposition in a cathode sputtering apparatus
Cathode de pulvérisation pour dépôt sur un substrat dans un appareil de pulvérisation

(30) Priorität: 31.12.1990 DE 4042286
(43) Veröffentlichungstag der Anmeldung: 08.07.1992
(73) Patentinhaber: Unaxis Deutschland Holding GmbH, 63450 Hanau (DE)
(72) Erfinder: Kukla, Reiner, W-6450 Hanau 9 (DE); Sichmann, Eggo, Dipl.-Ing., W-6460 Gelnhausen (DE); Fritsche, Wolf-Eckart, Dipl.-Ing., W-8752 Kleinostheim (DE)

(56) Entgegenhaltungen:
- EP-A- 0 210 473
- EP-A- 0 330 445
- GB-A- 2 078 787
- US-A- 4 486 287
- US-A- 4 604 180

## Beschreibung

Die Erfindung betrifft eine Zerstäubungskatode für die Beschichtung von Substraten in Katodenzerstäubungsanlagen mit einem Katodengrundkörper und einem darauf angeordneten Hohltarget mit mindestens einer ebenen, ringförmigen Zerstäubungsfläche, die von zwei in sich geschlossenen konzentrischen Vorsprüngen welche sich in Zerstänbungsrichtung erstrecken, umschlossen ist, sowie einer Magnetanordnung mit beiderseits des Hohltargets liegenden Polflächen entgegengesetzter Polung zur Erzeugung von im wesentlichen parallel zur Zerstäubungsfläche verlaufenden Magnetfeldlinien.

Es sind Zerstäubungskatoden für die Beschichtung von Substraten in Katodenzerstäubungsanlagen bekannt (DE-OS 35 27 626, US-PS 4 486 287), die im wesentlichen aus einem Katodengrundkörper, einem darauf angeordneten Hohltarget sowie einer das Target umfassenden Magnetanordnung bestehen und aufgrund ihrer Ausführungsform auch als ZPT-Hohlmagnetron (ZPT = Zwischen-Pol-Target) bezeichnet werden. Die in solchen Hohlmagnetrons üblicherweise verwendeten Hohltargets weisen in sich geschlossene konzentrische Vorsprünge auf, wobei die sich an die Zerstäubungsfläche anschließenden Wandflächen der Vorsprünge des Targets bislang lotrecht zur Zerstäubungsfläche in Zerstäubungsrichtung angeordnet sind.

Durch diese Ausführungsform stellen sich zwei gegenläufige Erscheinungen ein, die sich bislang nicht miteinander vereinbaren ließen: Einerseits möchte man einen Verlauf der Magnetfeldlinien parallel zur Zerstäubungsfläche erreichen, um eine möglichst hohe Zerstäubungsrate zu erzielen. Andererseits treten die Magnetfeldlinien in im wesentlichen senkrechter Richtung aus der einen, sich an die Zerstäubungsfläche anschließenden Wandfläche des einen Vorsprungs des Targets aus und nach dem Überqueren der Zerstäubungsfläche in die andere, gegenüberliegende Wandfläche des anderen Vorsprungs in im wesentlichen senkrechter Richtung wieder ein. Da diese Wandflächen von den Magnetfeldlinien im wesentlichen in senkrechter Richtung durchdrungen werden, stehen diese für die Zerstäubung nicht mehr zur Verfügung; im Gegenteil, der während des Zerstäubungsprozesses von der Zerstäubungsfläche abgelöste Werkstoff schlägt sich auf diesen Wandflächen nieder und baut mit Nachteil eine an diesen Flächen unerwünschte Schicht auf. Nachdem sich durch den Zerstäubungsprozeß mit metallischem Targetwerkstoff eine ausreichende Schichtdicke eingestellt hat, kommt es zum Abplatzen der sich einstellenden Schicht in den genannten Targetbereichen, was zur Unbrauchbarkeit des zu beschichtenden Substrats und zwangsläufig zum Ausfall der gesamten Zerstäubungsanlage führt.

Im Reaktivbetrieb der Zerstäubungskatode findet eine unerwünschte Belegung der Targetränder mit dielektrischem Werkstoff statt, was zum Arcing und somit ebenso zur Abschaltung des Zerstäubungsprozesses führt.

Der Erfindung liegt daher die Aufgabe zugrunde, eine Belegung der Wandflächen der Targetvorsprünge mit Targetwerkstoff zu vermeiden und die Vorteile des Hohlmagnetrons zu erhalten, d.h. einen guten seitlichen elektrostatischen Einschluß des Plasmas und eine gute Ausnutzung des Targetwerkstoffs zu erreichen.

Diese Aufgabe wird erfindungsgemäß dadurch gelöst, daß die einander gegenüberliegenden, sich an die Zerstäubungsflächen anschließenden Wandflächen der Vorsprünge des Hohltargets jeweils in einem Winkel α von 30 bis 70 Grad zur Lotrechten der Zerstäubungsfläche angeordnet sind.

Das erfindungsgemäße Hohltarget für eine Zerstäubungskatode zur Beschichtung von Substraten in Katodenzerstäubungsanlagen weist alle Vorteile der bislang angewandten Hohltargets auf und vermeidet sowohl im metallischen wie im reaktiven Betrieb das unerwünschte Beschichten der Wandflächen der Targetvorsprünge mit Targetwerkstoff.

Weitere Ausführungsmöglichkeiten und Merkmale sind in den Unteransprüchen näher beschrieben und gekennzeichnet.

Die Erfindung läßt die verschiedensten Ausführungsmöglichkeiten zu; eine davon ist in den anhängenden Zeichnungen näher dargestellt, und zwar zeigen:
- Fig. 1: einen halben Axialschnitt durch ein Ausführungsbeispiel der wesentlichen Teile einer Rundkatode mit erfindungsgemäßen Hohltarget für die Katodenzerstäubung,
- Fig. 2: ein kreisringförmiges Hohltarget konventioneller Bauart im Schnitt und in vergrößerter Darstellung und
- Fig. 3: ein erfindungsgemäßes Hohltarget gemäß Figur 1 im Schnitt und in vergrößerter Darstellung.

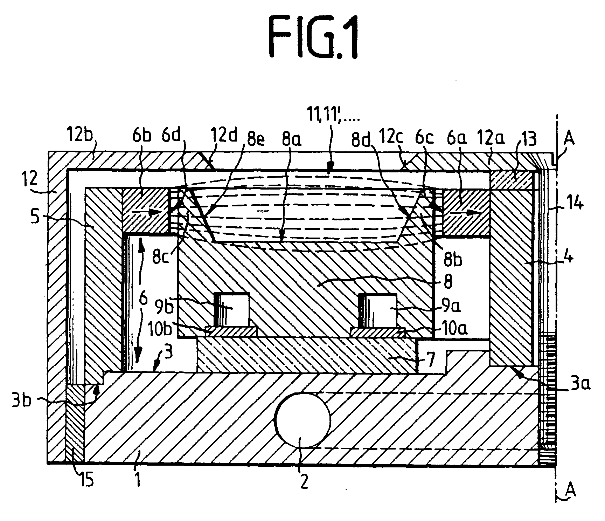

In Figur 1 ist ein Katodengrundkörper 1 dargestellt, der aus einem ferromagnetischen Werkstoff besteht und gleichzeitig das Magnetjoch für das nachfolgend näher beschriebene Magnetsystem bildet. Der Katodengrundkörper 1 besteht aus einem im wesentlichen scheibenförmigen Körper mit einem ringförmigen Kühlkanal 2. Auf einer oberen Ebene 3 des Grundkörpers 1 sind ringförmige Auflageflächen 3a, 3b vorgesehen, die zur Zentrierung einer Hülse 4 und eines Rings 5 dienen, wobei beide Teile aus weichmagnetischem Werkstoff hergestellt sind. An beide Teile 4, 5 schließen sich die Permanentmagnete 6a, 6b einer Magnetanordnung 6 an. Es handelt sich um einen inneren Ringmagneten 6a und einen äußeren Ringmagneten 6b, die beide in bezug auf die Mittenachse A-A des Systems in radialer Richtung magnetisiert sind, und zwar derart, daß die Polungsrichtung (siehe Pfeile) beider Magnete 6a, 6b nach innen zur Achse A-A hin zeigen. Die Magnete 6a, 6b weisen auf ihrer äußeren bzw. inneren zylindrischen Mantelflächen jeweils Polflächen auf, wobei die Polflächen 6c, 6d gegenüberliegend angeordnet sind.

Zwischen den beiden Auflageflächen 3a, 3b liegt auf der oberen Ebene 3 des Katodengrundkörpers 1 ein ringförmiger Isolierkörper 7, der zur Abstützung eines Hohltargets 8 dient. Dieses Target 8 stellt den Ausgangswerkstoff für die zu erzeugende Schicht, die auf einem nicht näher dargestellten Substrat niedergeschlagen werden soll. Das Target 8 besteht im wesentlichen aus einem ringförmigen Grundkörper, der in seiner Schnittdarstellung eine ebene Zerstäubungsfläche 8a aufweist, die beiderseits von zwei in sich geschlossenen konzentrischen Vorsprüngen 8b, 8c begrenzt ist, welche sich in Zerstäubungsrichtung erstrecken und aus dem gleichen Werkstoff bestehen wie der übrige Teil des Targets 8. Die Vorsprünge 8b, 8c besitzen aufeinander zugerichtete Wandflächen 8d, 8e, die in einem Böschungswinkel schräg zur Ebene der Zerstäubungsfläche 8a verlaufen.

Um die bei der Zerstäubung in das Target 8 eintretende Wärmemenge abführen zu können, sind in der der oberen Ebene 3 gegenüberliegende Seite des Targets 8 konzentrisch verlaufende Kühlkanäle 9a, 9b angeordnet, die durch Ringscheiben 10a, 10b verschlossen sind.

Die Polflächen 6c, 6d beiderseits der Vorsprünge 8b, 8c sind soweit über die Ebene der Zerstäubungsfläche 8a in Zerstäubungsrichtung vorgezogen, daß die Magnetfeldlinien 11, 11' ... in im wesentlichen senkrechter Richtung aus der einen Polfläche 6b austreten und nach dem Überqueren der Zerstäubungsfläche 8a in die andere gegenüberliegende Polfläche 6c des anderen Magneten 6a in im wesentlichen senkrechter Richtung wieder eintreten.

Das Magnetsystem 6 ist von einer Abschirmung 12 umgeben, die aus einem scheibenförmigen, zentralen Teil 12a und einem ringförmigen peripheren Teil 12b besteht. Der zentrale Teil 12a liegt über einen Distanzring 13 auf der Hülse 4 auf und ist über eine Schraube 14 elektrisch leitend mit dem Katodengrundkörper 1 verbunden. Der periphere Teil 12b ist über einen weiteren Distanzring 15 mit dem Katodengrundkörper 1 elektrisch leitend verbunden. Die beiden einander gegenüberliegenden Ränder 12c, 12d der Abschirmung 12 übergreifen auch die in Zerstäubungsrichtung zeigenden Stirnseiten der Vorsprünge 8b, 8c.

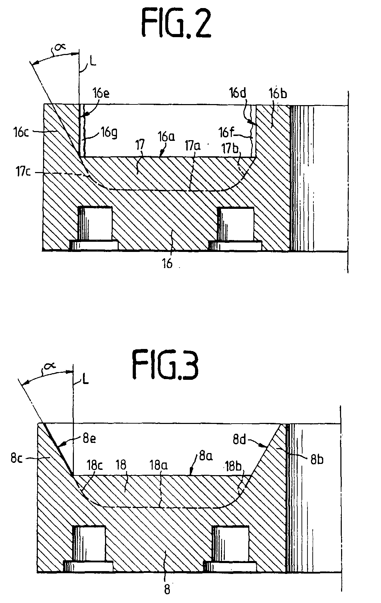

Die Vorsprünge 16b, 16c eines konventionellen Hohltargets 16 (Figur 2) sind so ausgebildet, daß die Wandflächen 16d, 16e lotrecht zur Zerstäubungsfläche 16a verlaufen. Dadurch entstehen auf den Flächen 16d, 16e Schichten 16f, 16g aus zerstäubtem Targetwerkstoff, der sich hier niederschlägt und dessen Oberfläche eine unregelmäßige zerklüftete Form einnimmt. Zwischen den beiden Wandflächen 16d, 16e bildet sich in der Zerstäubungsfläche 16a ein wannenförmiger Sputtergraben 17 (strichliert dargestellt), der eine untere Begrenzungslinie 17a aufweist, die etwa parallel zur Ebene der ursprünglichen Zerstäubungsfläche 16a verläuft, und der weiterhin zwei seitliche Begrenzungslinien 17b, 17c aufweist, die in einem Winkel α, dem Böschungswinkel, zu den Wandflächen 16d, 16e verlaufen.Ein erfindungsgemäßes Target 8 (Figur 3) unterscheidet sich, im Vergleich zu dem in Figur 2 beschriebenen Target 16 dadurch, daß die Wandflächen 8d, 8e der Vorsprünge 8b, 8c nicht lotrecht zur Zerstäubungsfläche 8a angeordnet sind, sondern in Verlängerung der seitlichen Begrenzungslinien 18b, 18c des sich einstellenden Sputtergrabens 18 in einem Winkel α verlaufen. Der Böschungswinkel α liegt zwischen 30 und 70 Grad zur Lotrechten der Zerstäubungsfläche 8a . Die untere Begrenzungslinie 18a des Sputtergrabens 18 verläuft etwa parallel zur ursprünglichen Zerstäubungsfläche 8a.

## Patentansprüche

1. Zerstäubungskatode für die Beschichtung von Substraten in Katodenzerstäubungsanlagen mit einem Katodengrundkörper (1) und einem darauf angeordneten Hohltarget (8) mit mindestens einer ebenen, ringförmigen Zerstäubungsfläche (8a), die von zwei in sich geschlossenen konzentrischen Vorsprüngen (8b, 8c), welche sich in Zerstäubungsrichtung erstrecken, umschlossen ist, sowie einer Magnetanordnung (6) mit beiderseits des Hohltargets (8) liegenden Polflächen (6c, 6d) entgegengesetzter Polung zur Erzeugung von im wesentlichen parallel zur Zerstäubungsfläche (8a) verlaufenden Magnetfeldlinien (11, 11',...), **dadurch gekennzeichnet, dass** die einander gegenüberliegenden, sich an die Zerstäubungsfläche (8a) anschliessenden Wandflächen (8d, 8e) der Vorsprünge (8b, 8c) des Hohltargets (8) jeweils in einem Winkel (α) von 30 bis 70 Grad zur Lotrechten (L) der Zerstäubungsfläche (8a) angeordnet sind.

2. Zerstäubungskatode nach Anspruch 1, **dadurch gekennzeichnet, dass** die Erstreckungssrichtungen der einander gegenüberliegenden, sich an die Zerstäubungsfläche (8a) anschliessenden Wandflächen (8d, 8e) der Vorsprünge (8b, 8c) etwa in Verlängerung der Böschungen (18b, 18c) des sich beim Betrieb einstellenden Sputtergrabens (18) verlaufen.

3. Zerstäubungskatode nach Anspruch 1 oder 2, **dadurch gekennzeichnet, daß** die Vorsprünge (8b, 8c) aus dem gleichen Werkstoff wie die Zerstäubungsfläche (8a) bestehen.

4. Zerstäubungskatode nach Anspruch 1 oder 2, **dadurch gekennzeichnet, daß** die Vorsprünge (8b, 8c) aus einem vom Werkstoff der Zerstäubungsfläche (8a) abweichenden Werkstoff gebildet sind.

## Claims

1. A sputtering cathode for coating substrates in cathodic sputtering installations comprising a cathode main body (1) and a hollow target (8) arranged thereon, with at least one flat annular sputtering surface (8a) which is surrounded by two concentric projections (8b, 8c) which are closed in themselves and which extend in the sputtering direction, and a magnet arrangement (6) with pole surfaces (6c, 6d) of opposite polarity, on both sides of the hollow target (8), for producing magnetic field lines (11, 11', ...) extending substantially parallel to the sputtering surface (8a), **characterised in that** the mutually oppositely disposed wall surfaces (8d, 8e), which adjoin the sputtering surface (8a), of the projections (8b, 8c) of the hollow target (8) are respectively arranged at an angle (α) of from 30 to 70° relative to the perpendicular (L) to the sputtering surface (8a).

2. A sputtering cathode according to claim 1 **characterised in that** the directions in which there extend the mutually oppositely disposed wall surfaces (8d, 8e) of the projections (8b, 8c), which adjoin the sputtering surface (8a), extend approximately in line with the banks (18b, 18c) of the sputtering pit (18) which occurs in operation.

3. A sputtering cathode according to claim 1 or claim 2 **characterised in that** the projections (8b, 8c) comprise the same material as the sputtering surface (8a).

4. A sputtering cathode according to claim 1 or claim 2 **characterised in that** the projections (8b, 8c) are formed from a material differing from the material of the sputtering surface (8a).

## Revendications

1. Cathode de pulvérisation pour le recouvrement de substrats dans des installations de pulvérisation cathodique comportant un corps de base de cathode (1) et une cible creuse (8) qui est disposée sur ce dernier et qui comprend au moins une surface de pulvérisation (8a) plane et en forme d'anneau qui est entourée par deux parties saillantes (8b, 8c) concentriques qui se referment sur elles-mêmes et qui s'étendent dans la direction de la pulvérisation, ainsi qu'un dispositif d'aimant (6) qui comporte des faces polaires (6c, 6d) de polarités opposées qui se trouvent des deux côtés de la cible creuse (8), pour la production de lignes de champ magnétique (11, 11',...) qui s'étendent sensiblement parallèlement à la surface de pulvérisation (8a), **caractérisée en ce que** les surfaces de paroi (8d, 8e) des parties saillantes (8b, 8c) de la cible creuse (8), qui sont opposées l'une à l'autre et se raccordent à la surface de pulvérisation (8a), sont disposées, à chaque fois, sous un angle (α) compris entre 30 et 70 degrés par rapport à la verticale (L) de la surface de pulvérisation (8a).

2. Cathode de pulvérisation selon la revendication 1, **caractérisée en ce que** les directions de l'extension des surfaces de paroi (8d, 8e) des parties saillantes (8b, 8c), qui sont opposées l'une à l'autre et se raccordent à la surface de pulvérisation (8a), s'étendent sensiblement dans la prolongation des talus (18b, 18c) de la tranchée de pulvérisation (18).

3. Cathode de pulvérisation selon la revendication 1 ou 2, **caractérisée en ce que** les parties saillantes (8b, 8c) sont réalisées avec la même matière que celle de la surface de pulvérisation (8a).

4. Cathode de pulvérisation selon la revendication 1 ou 2, **caractérisée en ce que** les parties saillantes (8b, 8c) sont réalisées en une matière différente de la matière de la surface de pulvérisation (8a).
